# EUROPEAN PATENT APPLICATION

(11) **EP 1 693 901 A1**
(43) Date of publication of application: **23.08.2006**
(21) Application number: 05112823.9
(22) Date of filing: 22.12.2005
(51) Int. Cl.: H01L 31/052, H02N 6/00

(54) **Generator of photovoltaic energy with co-generation of thermal energy**

(30) Priority: 22.02.2005 IT VA20050010
(71) Applicant: BIUCCHI, Sergio, 21049 Tradate (IT); MANTOVANI, Marco, 21049 Tradate (IT)
(72) Inventor: BIUCCHI, Sergio, 21049 Tradate (IT); MANTOVANI, Marco, 21049 Tradate (IT)
(74) Representative: Borsano, Corrado

(57) **Abstract**

It is described a generator of photovoltaic energy, comprising a containing room for the reflection of solar energy, and photovoltaic cells hit by said solar energy internally to said containing room. In addition the photovoltaic cells of the multiplier are connected to a cooling system, positioned next to said cells, to get a cogeneration system for photovoltaic and thermal energy.

## Description

The present invention refers to a multiplier of photovoltaic energy with cogeneration of thermal energy.

Nowadays there are various systems to transform the solar energy into thermal and electrical energy: through direct exposure of liquids or through photoelectric effect; through photovoltaic cells or through the use of lenses for the concentration of the light. If on the one hand these systems allow to obtain a greater power, on the other hand they do not totally satisfy the market requirements, because they do not fully resolve the problem of complete use of the solar light.

Therefore the purpose of the present invention is to overcome all the above drawbacks and to indicate a multiplier of photovoltaic energy with cogeneration of thermal energy which allows to get higher efficiency in a minimal space with respect to the known systems.

It is an object of the present invention a device multiplier of photovoltaic energy, characterized in that it comprises a containing room for the concentration of solar energy, and photovoltaic cells hit by said solar energy internally to said containing room.

It is another object of the present invention a cogeneration system for photovoltaic and thermal energy in which the photovoltaic cells of the multiplier are connected to a cooling system, positioned next to said cells.

It is a particular object of the present invention a multiplier of photovoltaic energy with cogeneration of thermal energy, as described in the attached claims, which are considered an integral part of the present description.

Further object s and advantages of the present invention will become fully clear from the following detailed description, given by way of a mere exemplifying and non limiting example, to be read with reference to the attached drawing figures, wherein:
- Figures 1 and 2 show a basic diagram of the multiplier of photovoltaic energy subject of the invention;
- Figure 3 shows a structural drawing of the photovoltaic multiplier, with side section;
- Figure 4 shows the whole of the frame for the construction of the photovoltaic multiplier;
- Figure 5 shows an upper sight of the structural drawing of the photovoltaic multiplier;
- Figure 6 shows the cooling system of the photovoltaic cells to get a photovoltaic and thermal cogeneration;
- Figure 7 shows a view as a whole of the photovoltaic multiplier.

The same reference numerals and letters in the figures designate the same components.

The present invention concerns a Multiplier of Photovoltaic Energy comprising a container control room for the solar energy concentration, and for the cogeneration of Thermal Energy, with a cells cooling system. The concentration of the solar energy in the Multiplier of Photovoltaic Energy allows to obtain high efficiency in a minimal space, especially using multi and/or triple splice cells with thin films, or new cells of last generation, for example plastic cells, thin film cells, etc..

The photovoltaic multiplier subject of the invention is a concentration system for photovoltaic energy, that is a whole of mechanical, electronic and electrical elements that concur to receive and transform, in a minimal space, the available solar energy, rendering it usable as electric power.

Moreover, through a cooling circuit for cells and a micro heat exchanger, thermal energy can be obtained as well.

The device can be classified for two main categories of distribution of electric energy: the one connected to the electrical network (grid-connected) and the remote one (stand-alone).

In the first one, the generated power is transmitted to a converter (inverter) from which it exits under the shape of alternating current, such as to be successively transformed by the transformer into medium voltage current, before being introduced in the distribution line.

The remote systems can feed loads in direct current (without inverter) as well as in alternating current, but they are generally equipped with storing facility. In the latter type of photovoltaic system it is necessary to store the electric power in order to guarantee the continuity of the distribution also in the moments in which it is not produced; this happens through electrochemical storage cells (batteries).

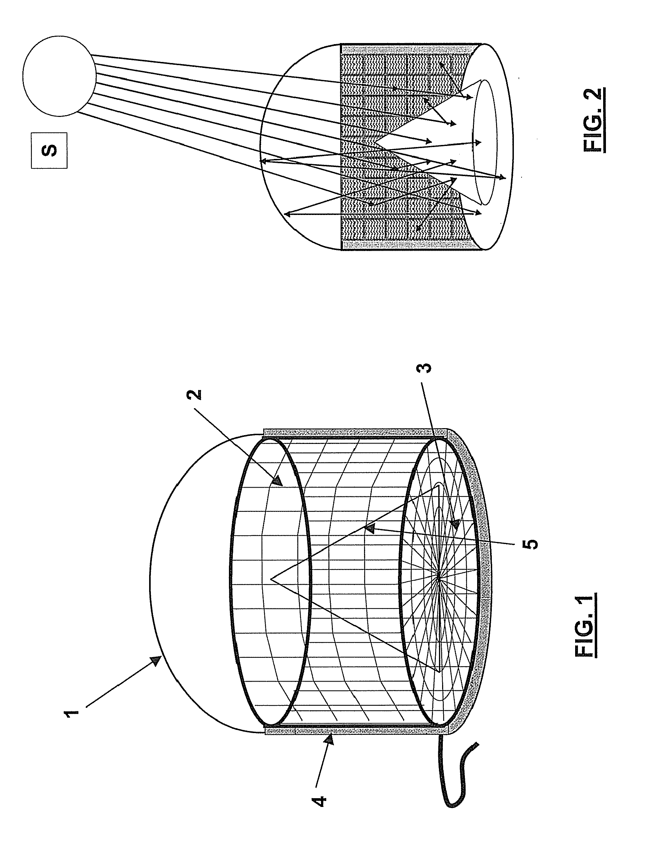

The network connected system, instead, is not equipped with storing facility systems, as the energy produced during insolation hours is directly introduced in the electrical net; vice versa, during the hours of insufficient or null insolation, the local load is fed by the net. With reference to Fig. 1, it is represented in transparency a basic scheme of the energy photovoltaic multiplier, with the main components highlighted.

Reference 1 indicates a Cupola for absorption and control of the solar energy, with 4 a Control room for containment of the multiplier of photovoltaic energy. The room 4 in the described example has a cylindrical form comprising essentially: a Cylinder covering 2 with new photovoltaic cells , for example Fresnel-lens solar concentrators with triple junction cells; a Cylinder base 3 with reflecting covering; a Reflecting cone 5 for concentration and exploitation of the solar energy.

With reference to Fig. 2, the way of working of the solar energy absorption of the photovoltaic multiplier is explained.

The photonic energy of the sun S penetrates the Control room 4 through the cupola 1. Internally to the cylinder the solar energy undergoes multiple reflections and refractions on the surfaces of the elements 2, 3, 5, remaining however within the multiplier, as the dome 1 has a reflecting internal surface. The internal temperature of the cupola reaches high values (i.e. 35 - 40 °C), and the solar rays are absorbed by the photovoltaic cells 2.

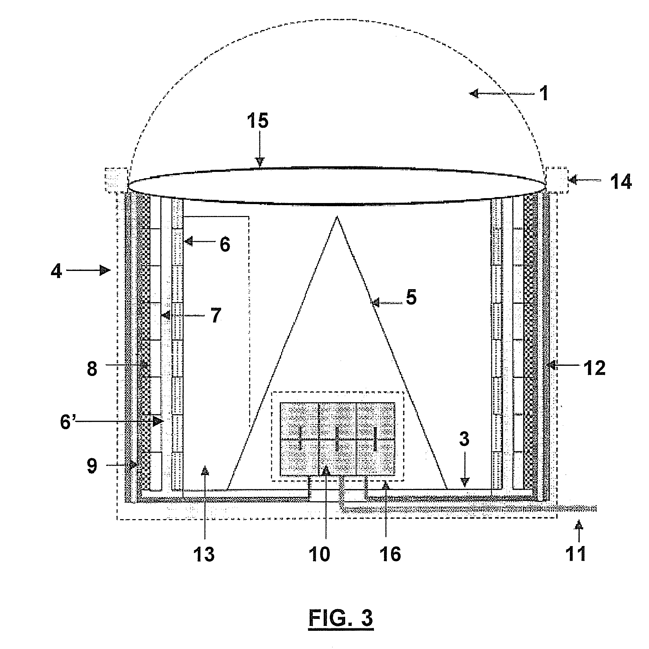

With reference to Fig. 3, the structural design of the photovoltaic multiplier is shown, with side section, and its components are shown in more details.

The photovoltaic cells 2 comprise successive layers of the following elements, from the internal to the wall of the control room 4: Fresnel lenses 6; cooling space 6', i.e. empty space; secondary optical concentrator 7; cells 8, i.e. of the multi and/or triple junction type, with thin film or new cells of last generation, like plastic cells, thin film cells, etc...

In addition it is present a layer of heat diffuser 9, i.e. copper, with electrical contact with solar storage cells (batteries), i.e. placed internally to the reflecting cone 5, with connecting cables 11 to the external space.

The various layers are kept housed in the control room 4 through a particular structure for their assembling, with adhesive conductor 12.

As described in the following, there are also present an entrance door 13 for maintenance of the photovoltaic room, attacks 14 for an automatic cleaning system for the cupola 1, which is connected to the control room through a gasket 15, an aperture 16 in the cupola for maintenance of the batteries.

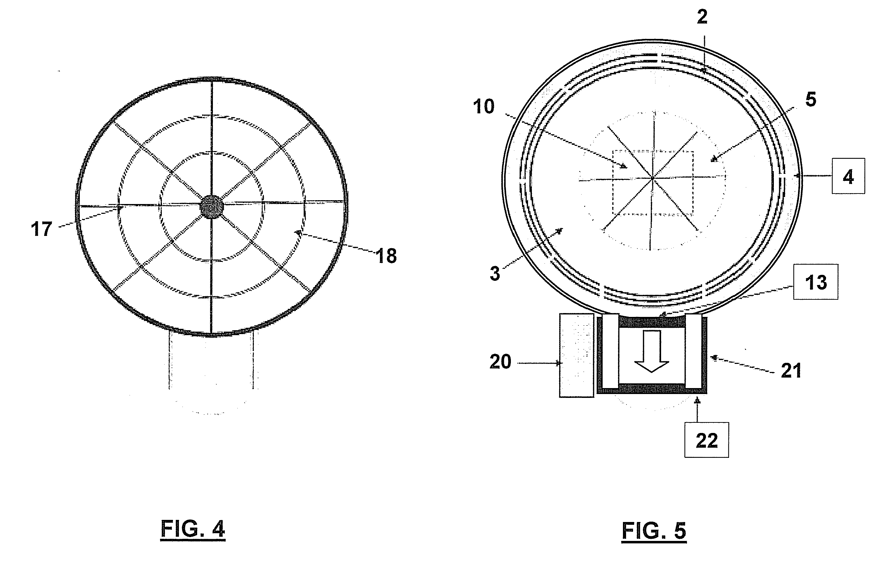

With reference to Fig. 4, it is represented the whole of the chassis for the cupola construction of the multiplier of photovoltaic energy, essentially comprising a Constructive of the chassis 17 for the control cupola of the solar energy , and

Curved glasses 18 for the absorption of the solar energy, such as to allow penetration of the solar rays internally to the room and forbid the exit.

Figure 5 shows an upper sight of the structural drawing of the photovoltaic multiplier.

It is shown the position of the solar energy storage elements 10 internal to the reflecting cone 5, the base for the reflecting mirror 3, the section for the photovoltaic panels 2, the position of the reflecting cone 5 with opening for inserting the batteries 10. The junctions for the connection of the solar panels are kept housed with conductive adhesive 12 to the control room, the aperture 13 of the room for photovoltaic concentration.

There are also provided an emplacement for inverters 20, transformer, electric frames, and auxiliary systems, an entrance 21 for maintenance, a lock-up (binary) 22 for the aperture of the room. This is in anticipation of a structure serving for a solar power plant which, being of great size, must provide for access to the internal space for periodic maintenance.

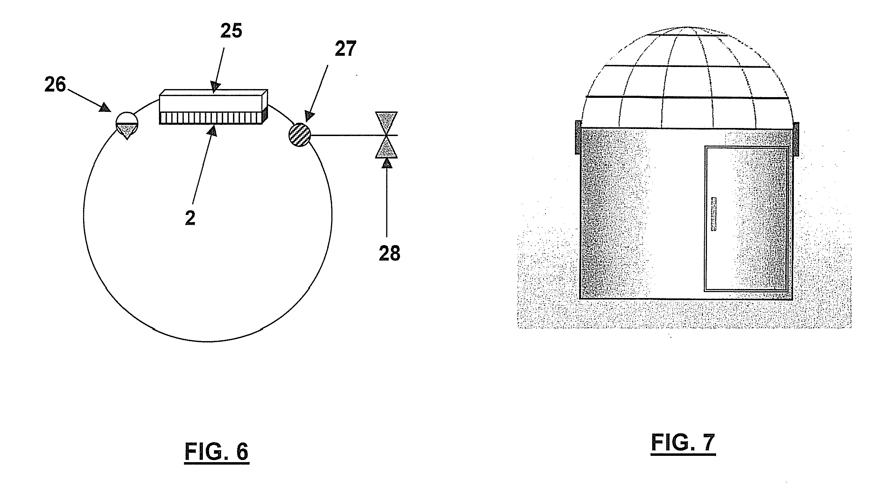

With reference to Fig. 6, it is represented the system of cells cooling in order to obtain a photovoltaic and thermal cogeneration.

The Cells of photovoltaic concentration 2 are connected to a cooling system 25, suitably positioned next to the cells 2. The cooling system 25 is on turn inserted in a circuit comprising a Pump 26 for the cooling circuit , an Heat exchanger 27, a Thermal Energy Escape 28, i.e. hot water. The exploitation of thermal energy allows the cooling of the cells in such a way as to get a better efficiency of the multiplier as a whole.

Figure 7 shows a view as a whole of the photovoltaic multiplier.

Variants to the described non limiting embodiment example are possible without departing from the scope of protection, comprising all the equivalent embodiments for a skilled in the art.

The advantages deriving from the use of the present invention are clear, primarily in terms of space reduction, efficiency increase, and cost reduction.

Further implementation details will not be described, as the man skilled in the art is able to carry out the invention starting from the teaching of the above description.

## Claims

1. Device multiplier of photovoltaic energy, **characterized in that** it comprises a containing room (1, 4) for the concentration of solar energy, and photovoltaic cells (2) hit by said solar energy internally to said containing room .

2. Device multiplier of photovoltaic energy as in claim 1, **characterized in that** said containing room comprises:
- a cupola (1) able to allow penetration and containment of the solar energy, having a reflecting internal surface;
- walls (2, 3, 5) of said containing room, on at least a part of said walls said photovoltaic cells are present, said walls also able to reflect said solar energy; so as said solar energy penetrates from the outside and is reflected towards the inside by the internal surface of said cupola and by said internal walls, so as to remain within said containing room and be supplied to said photovoltaic cells.

3. Device multiplier of photovoltaic energy as in claim 2, **characterized in that** said photovoltaic cells (2) are placed on lateral walls of said containing room.

4. Device multiplier of photovoltaic energy as in claim 2, **characterized in that** said walls of said containing room comprise a reflecting base (3).

5. Device multiplier of photovoltaic energy as in claim 3, **characterized in that** it comprises a conic reflecting surface (5) internal to said containing room, for reflecting said solar energy, said lateral walls being cylindrically developed.

6. Device multiplier of photovoltaic energy as in claim 1, **characterized in that** said photovoltaic cells (2) comprise cells (8) of the multi and/or triple junction type, with thin film or plastic or thin film cells.

7. Device multiplier of photovoltaic energy as in claim 6, **characterized in that** said photovoltaic cells (2) further comprise a front layer of Fresnel lenses for solar concentration.

8. Device multiplier of photovoltaic energy as in claim 7, **characterized in that** said photovoltaic cells (2) further comprise intermediate layers of cooling spaces and secondary optical concentrators (7).

9. Device multiplier of photovoltaic energy as in claim 6, **characterized in that** it further comprises a layer of heat diffuser (9) behind said cells (8).

10. Device multiplier of photovoltaic energy as in claim 9, **characterized in that** it said layer of heat diffuser (9) is equipped with electric contact to solar storage cells (10).

11. Device multiplier of photovoltaic energy as in claim 10, **characterized in that** said solar storage cells (10) are placed internally to said reflecting cone (5).

12. Device multiplier of photovoltaic energy as in any of claims 6 to 9, **characterized in that** said layers are kept housed through a structure set for the assembling, with conductive adhesive (12) to said lateral walls of said containing room (4).

13. Device multiplier of photovoltaic energy as in claim 1, **characterized in that** said cells for the photovoltaic concentration (2) are connected to a cooling system (25), positioned next to said cells (2), able to get a system for the photovoltaic and thermal cogeneration.

14. Device multiplier of photovoltaic energy as in claim 13, **characterized in that** it further comprises a pump (26), a heat exchanger (27), a termic energy escape (28).

15. Device multiplier of photovoltaic energy as in any of the preceding claims, **characterized in that** it further comprises one or more of the following elements:
- an entrance door (13) on said lateral walls, for maintenance of the photovoltaic room,
- attacks (14) for an automatic system for cleaning said cupola (1);
- an aperture for said cone (16) for maintenance of said storage cells (10);
- an entrance (21) for maintenance;
- a lock-up (binary) (22) for room opening.

16. Device multiplier of photovoltaic energy as in claim 2, **characterized in that** said cupola (1) comprises a frame (17) and curved glasses (18) having said reflecting internal surface.
